(19) Europäisches Patentamt
European Patent Office
Office européen des brevets

(11) **EP 4 228 006 A1**

(12) **EUROPEAN PATENT APPLICATION**
published in accordance with Art. 153(4) EPC

(43) Date of publication:
**16.08.2023 Bulletin 2023/33**

(21) Application number: **22879620.7**

(22) Date of filing: **15.09.2022**

(51) International Patent Classification (IPC):
***H01L 29/417*** (2006.01)

(86) International application number:
**PCT/CN2022/118904**

(87) International publication number:
**WO 2023/124246 (06.07.2023 Gazette 2023/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.12.2021 CN 202111629255**

(71) Applicant: **Hunan San'An Semiconductor Co., Ltd
Changsha, Hunan 410217 (CN)**

(72) Inventors:
• **CAI, Wenbi**
**Xiamen, Fujian 361110 (CN)**
• **LIU, Cheng**
**Xiamen, Fujian 361110 (CN)**
• **XU, Ning**
**Xiamen, Fujian 361110 (CN)**
• **YEH, Nien-Tze**
**Xiamen, Fujian 361110 (CN)**

(74) Representative: **De Arpe Tejero, Manuel
Arpe Patentes y Marcas
Alcalá, 26, 5ª Planta
28014 Madrid (ES)**

(54) **LATERAL FIELD-EFFECT TRANSISTOR AND PREPARATION METHOD THEREFOR**

(57)    The present disclosure provided a lateral field-effect transistor and its preparing method, relating to semiconductor technological field. A gate pad and a source pad configured by the lateral field transistor in a passive region extend from a first surface of a device functional layer to a surface of substrate respectively. The gate pad is isolated from the device functional layer and the substrate respectively. The source pad is shorted to the substrate. Therefore, through a capacitance structure formed between the gate pad and the source pad shorted to the substrate, the capacitance of a device that formed between the gate pad and source pad may be increased, thereby effectively alleviating the generated oscillation, reducing the loss of a power device, and avoiding the false turn-on of the lateral field-effect transistor.

FIG. 6

EP 4 228 006 A1

Description

**TECHNICAL FIELD**

The present disclosure relates to the technical field of semiconductor, in particular to a lateral field-effect transistor.

**BACKGROUND**

When lateral field-effect transistors (LDMOS/GaN HEMTs, etc.) are applied to hard switching, the gate driving signal will generate parasitic oscillations due to internal parasitic capacitance between gate and source, as well as wiring inductance, increasing the loss of a power device. When the oscillation amplitude is large, it may cause the lateral field-effect transistors to a false turn on.

The present lateral field-effect transistors (LDMOS/GaN HEMT, etc.) usually have a lower threshold voltage due to material and structural limitations. The present lateral field-effect transistors are more sensitive to the oscillation of the gate drive signal, which is more likely to cause a false turn-on of the lateral field-effect transistors.

**SUMMARY OF THE DISCLOSURE**

A lateral field effect transistor and its preparing method are provided in some embodiments in the present disclosure, focusing on the lack of the present technologies mentioned above, which may improve the oscillation of the gate driving signal when the lateral field effect transistor is used.

To achieve the purpose mentioned above, the technical solutions in some embodiments of the disclosure are as follows:

In an aspect, some embodiments in the present disclosure provide a lateral field-effect transistor. A gate pad and a source pad configured by the lateral field transistor in a passive region extend from a first surface of a device functional layer to a surface of substrate respectively. The gate pad is isolated from the device functional layer and the substrate respectively. The source pad is shorted to the substrate.

In another aspect, some embodiments in the present disclosure provide a method of preparing a lateral field-effect transistor. The method includes: preparing a first slot and a second slot in the passive region of the lateral field effect transistor, wherein the gate pad is partially filled in the first slot; the gate pad is isolated from the device functional layer and the substrate, respectively; the source pad is partially filled in the second slot and the source pad is shorted to the substrate.

The benefits of the present disclosure include:

improving the oscillation of the gate driving signal when the lateral field effect transistor is used.

**BRIEF DESCRIPTION OF THE DRAWINGS**

In order to more clearly illustrate the technical solutions in the embodiments of the present disclosure, a brief description of the accompanying drawings to be used in the description of the embodiments will be given below. It will be known that the accompanying drawings in the following description are only some embodiments of the present disclosure, and therefore should not be regarded as limiting the scope. Other accompanying drawings may be obtained on the basis of these drawings without any creative effort for those skilled in the art.

FIG. 1 is a top view of a lateral field-effect transistor provided in some embodiments of the disclosure.

FIG. 2 is a first-state schematic of the lateral field-effect transistor provided in some embodiments of the disclosure.

FIG. 3 is a second-state schematic of the lateral field-effect transistor provided in some embodiments of the disclosure.

FIG. 4 is a third state schematic of the lateral field-effect transistor provided in some embodiments of the disclosure.

FIG. 5 is a fourth state schematic of the lateral field-effect transistor provided in some embodiments of the disclosure.

FIG. 6 is a cross-sectional view of A-A' in FIG. 1.

FIG. 7 is a cross-sectional view of the lateral field-effect transistor provided in an active region in some embodiments of the disclosure.

FIG. 8 is a schematic of the distribution of parasitic parameters of the lateral field-effect transistor provided in the active region in some embodiments of the disclosure.

FIG. 9 is a flow chart of a preparing method of the lateral field-effect transistor provided in the active region in some embodiments of the disclosure.

Marks: active region 101; passive region 102; drain pad 103; gate pad 104; first slot 105; source pad 106; second slot 107; substrate 108; buffer layer 109; channel layer 110; barrier layer 111; photoresist layer 112; dielectric layer 113; passivation layer 116; source electrode 117; drain electrode118; p-doped layer 119; gate metal 120.

**DETAILED DESCRIPTION**

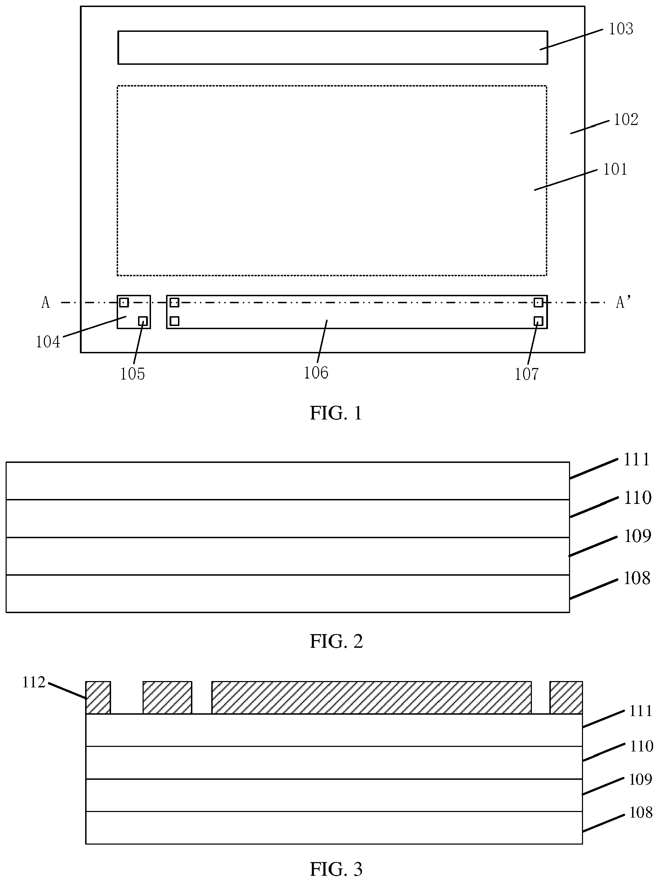

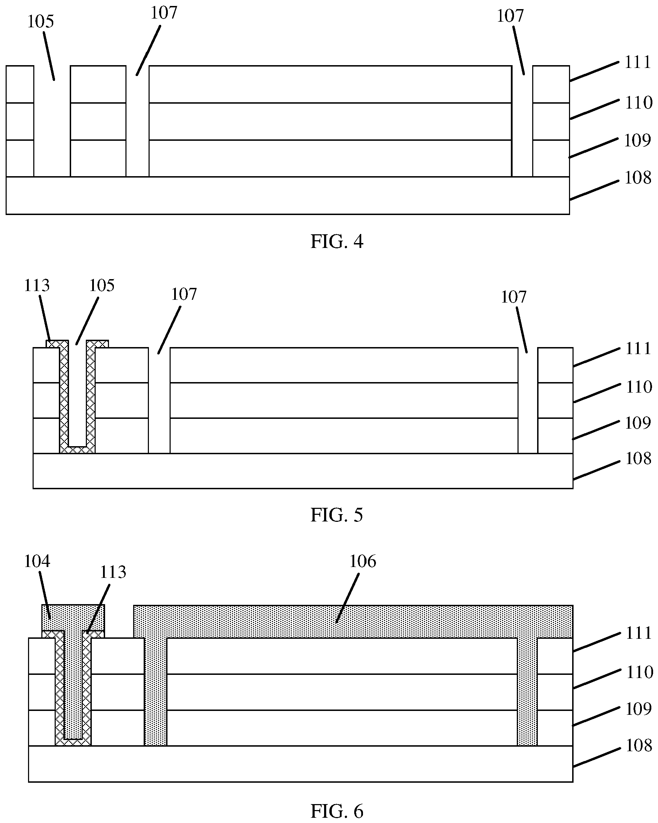

In an aspect, some embodiments of the present disclosure provide a lateral field-effect transistor. Referring to FIG. 1 and FIG. 6, the lateral field-effect transistor includes a substrate 108 and a device functional layer. The device functional layer is arranged on the substrate 108 and includes a first surface far away from the substrate 108. The lateral field-effect transistor is configured with an active region 101 and a passive region 102. The passive region 102 includes the substrate 108 and the device functional layer arranged on the substrate 108. The device functional layer includes a first surface far away from the substrate 108. A gate pad 104 is arranged in the passive region 102. The gate pad 104 extends from the first surface to a surface of the substrate 108. The gate pad 104 is insulated from the substrate 108 and the device functional layer. A source pad 106 is arranged in the passive region 102. The source pad 106 extends from the first surface to the surface of the substrate 108. The source pad 106 is shorted to the substrate 108.

The gate pad 104 and the source pad 106 configured by the lateral field transistor in the passive region extend from a first surface of a device functional layer to the surface of the substrate 108 respectively. The gate pad 104 is isolated from the device functional layer and the substrate 108 respectively. The source pad 106 is shorted to the substrate 108. Therefore, through a capacitance structure formed between the gate pad 104 and the source pad 106 shorted to the substrate 108, the capacitance of a device that formed between the gate pad 104 and source pad 106 may be increased, thereby effectively alleviating the generated oscillation, reducing the loss of a power device, and avoiding the false turn-on of the lateral field-effect transistor.

In some embodiments, referring to FIGS. 4 to 6, a first slot 105 corresponding to the gate pad 104 and a second slot 107 corresponding to the source pad 106 is arranged on the device functional layer in the passive region respectively. For the first slot 105, as shown in FIG. 4, the first slot 105 extends from the first surface of the device functional layer down to the substrate 108. As shown in FIG. 5, a first dielectric-layer portion covers the side wall and the bottom wall of the first slot 105. A second dielectric-layer portion is continuous with the first dielectric-layer portion and covers the first surface around the circumference of the first slot 105. As shown in FIG. 6, the second gate-pad portion fills the first slot 105 which is completely covered by the dielectric layer 113. The first gate-pad portion is arranged outside the first slot 105. The first gate-pad portion is continuous with the second gate-pad portion and arranged on the second dielectric-layer portion, thus forming a structure in which the gate pad 104 is insulated from the device functional layer and from the substrate 108 by the dielectric layer 113 respectively. For the second slot 107, as shown in FIG. 4, the second slot 107 also extends from the first surface of the device functional layer down to the surface of the substrate 108. As shown in FIG. 6, a second source pad portion directly fills in the second slot 107. A first source pad portion is arranged outside the second slot 107. The first source pad portion is continuous with the second source pad portion and covers the first surface around the circumference of the second slot 107, thus forming a structure in which the source pad 106 is shorted to the device functional layer and the substrate 108 respectively.

The lateral field-effect transistor is configured with the active region 101 and the passive region 102. The passive region 102 includes a first side portion at a side of the active region 101. The first slot 105 and the second slot 107 defined in the device function layer of the passive region 102 are both arranged in the first side portion, to avoid the first slot 105 and the second slot 107 being separated by the active region 101 causing a limited increase of a gate-source capacitance C in the device. For example, in some embodiments, as shown in FIG. 1, the passive region 102 surrounds the circumstance of the active region 101. The first side portion in the passive area 102 is closing to a side of the active region 101, which is shown in the bottom of FIG. 1. When both the first slot 105 and the second slot 107 defined on the functional layer in the device are arranged in the first side portion of the passive region 102, the structure may configure the positions of both the first slot 105 and the second slot 107 in the first side of the passive area 102, to avoid the first slot 105 and the second slot 107 being separated by the active region 101 causing a limited increase of a gate-source capacitance C in the device.

In some embodiments, the quantity of the first slot 105 defined in the device functional layer may be more than one, which may be reasonably configured according to actual requirements. For example, as shown in FIG. 1, when the quantity of the first slot 105 is two, the two first slot 105 may be distributed diagonally in the region of the positive projection of the gate pad 104 on the substrate 108.

In some embodiments, the quantity of the second slot 107 defined in the device functional layer may be also more than one, which may be reasonably configured according to actual requirements. For example, as shown in FIG. 1, when the quantity of the second slot 107 is four, the four second slot 107 may be distributed diagonally in the region of the positive projection of the gate pad 104 on the substrate 108.

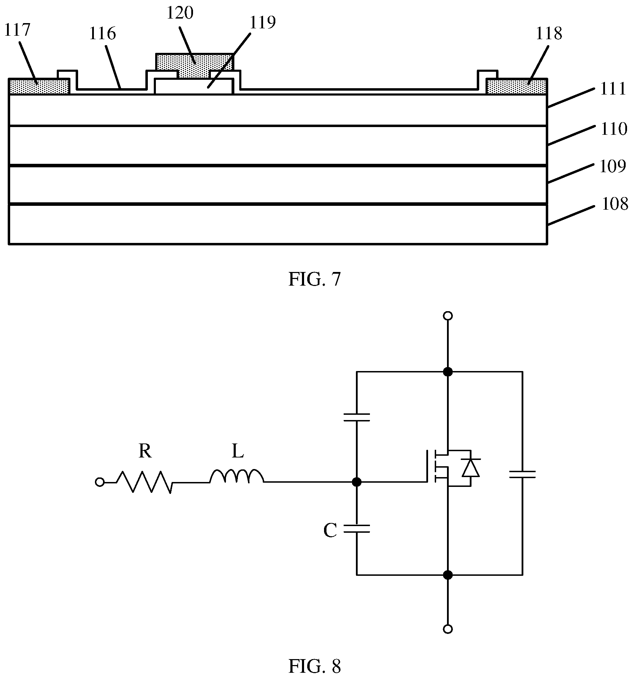

In some embodiments, referring to FIG. 6, the gate pad 104 and the source pad 106 are arranged in the passive region 102. As shown in FIG. 7, the lateral field-effect transistor also includes a gate electrode, a source electrode 117, and a drain 118 arranged in the active region 101, the gate pad 104 is electrically connected to the gate electrode, and the source pad 106 is electrically connected to the source electrode 117. When the lateral field-effect transistor is configured that the gate pad 104 is connected in series with a gate driving circuit, a resistance of a circuit structure formed by the connection of the gate electrode, the gate pad 104, and the gate driving circuit is R; a parasitic inductance of the circuit structure formed by the connection of the gate electrode, the gate pad 104, and the gate driving circuit is L; a gate-source capacitance in the lateral field-effect transistor is C. Through the gate pad 104 and the source pad 106 configured by the lateral field transistor in the passive region 102 extending from the first surface of the device functional layer to the surface of the substrate 108 respectively, and the source pad 106 being shorted to the substrate 108, a capacitance structure is formed between the gate pad 104 and the source pad 106 shorted to the substrate 108, which increases the capacitance of a device that formed between the gate pad 104 and the source pad 106. In some embodiments, as shown in FIG.8, the parasitic parameter distribution of the lateral field-effect transistor is illustrated. When $R > \frac{2\sqrt{LC}}{C}$ is satisfied, the lateral field-effect transistor may be performed in an overdamped state, which may further mitigate gate oscillation, reduce loss, and avoid false turn-on through the RLC series resonant circuit.

In some embodiments, as shown in FIG. 1, a drain pad 103 is also arranged in the passive region 102 of the functional layer. The drain pad 103 may be connected to a drain electrode 118 of an active device in the active region 101.

In some embodiments, the source pad 106 may be configured to be grounded. The drain electrode 118 may be configured to be connected to a power supply.

In some embodiments, since the dielectric layer 113 acts as a dielectric for the capacitance formed by the gate pad 104 and the source pad 106 shorted to the substrate 108, the magnitude of the device gate-source capacitance C may be adjusted correspondingly by changing the thickness and material of the dielectric layer 113. For example, when it is desired to adjust the device gate-source capacitance C at a certain value, the gate-source capacitance C may configure to be at a certain value by changing one or a combination of either the thickness and the material.

In some embodiments, the breakdown voltage of the capacitance formed by the gate pad 104 and the source pad 106 shorted to the substrate 108 may be higher than the actual operating voltage of the lateral field-effect transistor, so that the stability of the device may be effectively improved.

In some embodiments, the thickness and material of the dielectric layer 113 may be reasonably selected in view of the requirements of the breakdown voltage of the capacitance formed by the gate pad 104 and the source pad 106 and the requirements of the device gate-source capacitance C.

In some embodiments, the depth of the first slot 105 and/or the second slot 107 is greater than the thickness of the device functional layer. For example, a typical epitaxial thickness of 650V GaN HEMT is 5 $\mu$m, and the depth of the first slot 105 and/or the second slot 107 slot needs to be greater than 5 um, etched into the surface of the substrate 108.

In some embodiments, the thickness of the dielectric layer 113 can be greater than 5 nm, such as 5 nm, 10 nm, 15 nm, etc., so that the breakdown voltage requirement and the gate-source capacitance C may be matched. For example, when the GaN E-HEMT gate operating voltage is 6V, the dielectric material is SiO2, the typical breakdown electric field is 6MV/cm, the thickness of the dielectric layer 113 needs to be greater than 10nm.

In some embodiments, the material of the dielectric layer 113 may be selected from a group of $SiO_2$, $Si_3N_4$ and $Al_2O_3$. In some embodiments, the dielectric layer 113 may be a stack layer of Si3N4/Al2O3, which means the dielectric layer 113 is a dielectric stack, i.e., a Si3N4 layer is deposited first and then the Al2O3 layer continues to be deposited on top of the Si3N4 layer.

In some embodiments, the lateral field-effect transistor is a HEMT device, and the HEMT device includes a substrate 108 and a device functional layer arranged on the substrate 108. Both the substrate 108 and the device functional layer include a portion arranged in the active region 101 and a portion arranged in the passive region 102.

In some embodiments, the device functional layer may include a plurality of active semiconductor layers formed on the substrate 108. The plurality of active semiconductor layers is disposed in the active region 101 and the passive region 102. Two-dimensional electron gas (2DEG) is defined at hetero-interface(s) between two of the plurality of active semiconductor layers in the active region 101; and the 2DEG is not defined at hetero-interface(s) between two of the plurality of active semiconductor layers in the passive region 102 (the process of excluding the 2DEG may be ion implantation, etc.).

In some embodiments, when the lateral field-effect transistor is a HEMT device, the HEMT device includes a substrate 108 and a device functional layer formed on the substrate 108, wherein, as shown in FIG. 7, the plurality of active semiconductor layers included in the device functional layer may be: a nucleation layer (not shown in the figure) formed on the substrate 108, which reduces the lattice mismatch between the substrate 108 and the next active semiconductor layer; a buffer layer 109 and a channel layer 110 formed on the nucleation layer in sequence; a barrier layer 111 formed on the channel layer 110, with 2DEG formed between the channel layer 110 and the barrier layer 111 (the portion located in the passive region 102 is removed); a passivation layer 116 formed on the barrier layer 111; a source electrode 117 and a drain electrode 118 form on the passivation layer 116 in contact with the barrier layer 111; a gate electrode in contact with the barrier layer 111 is formed between the source electrode 117 and the drain electrode 118.

In some embodiments, the gate electrode may include a p-doped layer 119 formed on the barrier layer 111 and a gate metal 120 formed on top of the p-doped layer 119, as shown in FIG. 7.

In some embodiments, the substrate 108 is made of silicon carbide, sapphire, spinel, zinc oxide, silicon, gallium nitride, aluminum nitride, or any other material capable of supporting the growth of group III nitride materials.

In some embodiments, the nucleation layer may include a variety of different materials, such as $Al_xGa_{1-x}N$ $(0 \leq x \leq 1)$. The nucleation layer may be formed on the substrate 108 using present semiconductor growth technologies such as metal oxide chemical vapor deposition (MOCVD), hydride vapor phase epitaxy (HVPE), or molecular beam epitaxy (MBE).

In some embodiments, the buffer layer 109 and the channel layer 110 may be formed by a group III nitride material such as $Al_xGa_yIn_{1-x-y}N$ $(0 \leq x \leq 1, 0 \leq y \leq 1\ x + y \leq 1)$. For example, the buffer layer 109 and the channel layer 110 are GaN layers. In some other embodiments, the GaN layers can be doped with Fe. The buffer layer 109 and the channel layer 110 may be formed using the same methods as growing nucleation layers.

In some embodiments, each of the barrier layer 111 and the channel layer 110 may include doped or undoped group III nitride material. The barrier layer 111 may contain one or more layers of different materials such as InGaN, AlGaN, AlN, or combinations thereof. The barrier layer 111 can be fabricated using the same methods used to grow the nucleation layer.

In some embodiments, the source pad 106 is made of one of titanium, aluminum, gold, and nickel, or an alloy of several of titanium, aluminum, gold, and nickel; in some embodiments, the gate pad 104 is made of one of nickel, gold, platinum, titanium, chromium, titanium, and tungsten, or an alloy of several of nickel, gold, platinum, titanium, chromium, titanium, and tungsten, or platinum silicide; in some embodiments, the drain pad 103 is of one of titanium, aluminum, gold, and nickel, or an alloy of several of titanium, aluminum, gold, and nickel. In some embodiments, the material of the source electrode 117 is one of titanium, aluminum, gold, and nickel, or an alloy of several of titanium, aluminum, gold, and nickel; in some embodiments; in some embodiments, the material of the gate electrode is one of nickel, gold, platinum, titanium, chromium, titanium, and tungsten, or an alloy of several of nickel, gold, platinum, titanium, chromium, titanium, and tungsten, or platinum silicide; in some embodiments, the material of the drain electrode 118 is one of titanium or an alloy of titanium, aluminum, gold, and nickel, or an alloy of several of titanium, aluminum, gold, and nickel.

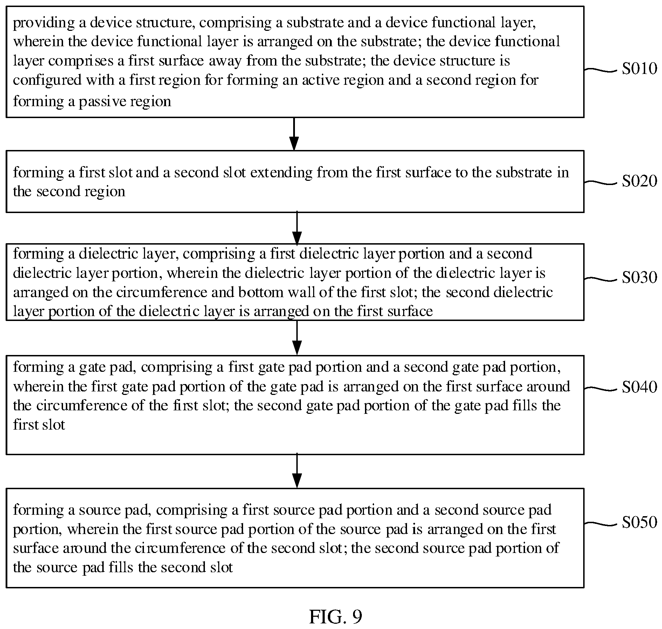

In another aspect, some embodiments of the present disclosure provide a method for preparing a lateral field-effect transistor, as shown in FIG. 9, the method includes:

S010: providing a device structure, including a substrate 108 and a device functional layer, wherein the device functional layer is arranged on the substrate 108; the device functional layer includes a first surface far away from the substrate 108; the device structure is configured with a first region for forming an active region 101 and a second region for forming a passive region 102.

S020: forming a first slot 105 and a second slot 107 extending from the first surface to the substrate 108 in the second region.

S030: forming a dielectric layer 113, including a first dielectric-layer portion and a second dielectric-layer portion, wherein the first dielectric-layer portion is arranged on the circumference and bottom wall of the first slot 105; the second dielectric-layer portion is arranged on the first surface.

S040: forming a gate pad 104, including a first gate-pad portion and a second gate-pad portion, wherein the first gate-pad portion is arranged on the first surface around the circumference of the first slot 105; the second gate-pad portion fills the first slot 105.

S050: forming a source pad 106, including a first source pad portion and a second source pad portion, wherein the first source pad portion of the source pad 106 is arranged on the first surface around the circumference of the second slot 107; the second source pad portion of the source pad 106 fills the second slot 107.

Since the present disclosure does not change the structure of the active device in the active region 101, it is also able to reduce the magnitude of the modification of the original device process and reduce costs. Further, both the second slot 107 and the first slot 105 of the disclosure are located in an original source pad region and the gate pad region, so it is also able to avoid an additional occupied region, which leads to increase device size.

In some embodiments, for S010: as shown in FIG. 2, the device structure includes the substrate 108 108 and a device functional layer, the device functional layer is arranged on the substrate 108 and includes a first surface far away from the substrate 108. The device structure is configured with a first region and a second region. The active region 101 may be formed by the first region and the passive region 102 may be formed by the second region. The specific fabrication method may be etching or ion implantation of the second region such that the second region forms the passive region 102, while the first region acts as the active region 101.

In some embodiments, for S020: as shown in FIG. 3, a full photoresist layer 112 may be coated on the first surface of the device functional layer of the passive region 102, and then the device functional layer may be exposed through some windows by the process of exposing and developing in the photoresist layer 112 to define the positions of the first slot 105 and the second slot 107. As shown in FIG. 4, the device functional layer is etched at the windowed position to form the first slot 105 and the second slot 107 on the device functional layer, respectively. During etching, the first slot 105 and the second slot 107 formed by etching may be configured to extend from the first surface of the device functional layer to the surface of the substrate 108, thus the surface of the substrate 108 is exposed in the first slot 105 and the second slot 107. Then, the photoresist layer 112 is lifted off.

In some embodiments, for S030: as shown in FIG. 5, a full layer of dielectric layer 113 may be deposited on the device functional layer, retaining the first dielectric-layer portion covering the side wall and bottom wall of the first slot 105 as well as the dielectric-layer portion continuous with the first dielectric-layer portion and covering the first surface around the circumference of the first slot 105, by etching.

In some embodiments, for S040: as shown in FIG. 6, the gate pad 104 may be made by lithography, vapor deposition, and metal stripping. Depending on the position of the windows, the second gate-pad portion 104 fills the first slot 105 which is completely covered by the dielectric layer 113. The first gate pad 104 portion is arranged outside the first slot 105. The first gate-pad portion is continuous with the second gate-pad portion and is arranged above the second dielectric-layer portion, thereby forming a structure in which the gate pad 104 is insulated from the device functional layer and from the substrate 108 by the dielectric layer respectively.

In some embodiments, for S050: as shown in FIG. 6, the gate pad 104 may be made by lithography, vapor deposition, and metal stripping. Depending on the position of the windows, the second source pad portion is directly filled in the second slot 107. The first source pad portion is arranged outside of the second slot 107. The first source pad portion is continuous with the second source pad portion and covers the first surface around the circumference of the second slot 107, thereby forming a structure in which the source pad 106 is shorted to the device functional layer and the substrate 108 respectively.

In some embodiments, as shown in FIG. 7, when forming the active device on the device functional layer of the active region 101, a full passivation layer 116 may be formed on the surface of the device functional layer first, and then a source window and a drain window may be formed on the passivation layer 116 by photolithography, vapor deposition, and metal stripping processes, respectively. Similarly, with reference to the process of forming the source window and the drain window, etch the passivation layer 116, form a gate slot on the passivation layer 116, which is defined between the source electrode 117 and the drain electrode 118, and then forming the gate electrode in the gate slot.

The lateral field-effect transistor is configured with the active region 101 and the passive region 102. The passive region 102 includes a first side portion at a side of the active region 101. The first slot 105 and the second slot 107 defined in the device function layer of the passive region 102 are both arranged in the first side portion, to avoid the first slot 105 and the second slot 107 being separated by the active region 101 causing a limited increase of a gate-source capacitance C in the device. For example, in some embodiments, as shown in FIG. 1, the passive region 102 surrounds the circumstance of the active region 101. The first side portion in the passive area 102 is closing to a side of the active region 101, which is shown at the bottom of FIG. 1. When both the first slot 105 and the second slot 107 defined on the functional layer in the device are arranged in the first side portion of the passive region 102, the structure may configure the positions of both the first slot 105 and the second slot 107 in the first side of the passive area 102, to avoid the first slot 105 and the second slot 107 being separated by the active region 101 causing a limited increase of a gate-source capacitance C in the device.

In some embodiments, the quantity of the second slot 107 defined in the device functional layer may be also more than one, which may be reasonably configured according to actual requirements. For example, as shown in FIG. 1, when the quantity of the second slot 107 is four, the four second slot 107 may be distributed diagonally in the region of the positive projection of the gate pad 104 on the substrate 108.

In some embodiments, referring to FIG. 6, the gate pad 104 and a source pad 106 are arranged in the passive region 102. As shown in FIG. 7, the lateral field-effect transistor also includes a gate electrode, a source electrode 117, and a drain electrode 118 arranged in the active region 101, the gate pad 104 is electrically connected to the gate electrode, and the source pad 106 is electrically connected to the source electrode 117. When the lateral field-effect transistor is configured that the gate pad 104 is connected in series with a gate driving circuit, a resistance of a circuit structure formed by the connection of the gate electrode, the gate pad 104, and the gate driving circuit is R; a parasitic inductance of the circuit structure formed by connecting the gate electrode, the gate pad 104, and the gate driving circuit is L; a gate-source capacitance in the lateral field-effect transistor is C. Through the gate pad 104 and the source pad 106 configured by the lateral field transistor in the passive region 102 extending from the first surface of the device functional layer to the surface of the substrate 108 respectively, and the source pad 106 being shorted to the substrate 108, a capacitance structure is formed between the gate pad 104 and the source pad 106 shorted to the substrate 108, which increases the capacitance of a device that formed between the gate pad 104 and the source pad 106. In some embodiments, as shown in FIG.8, the parasitic parameter distribution of the lateral field-effect transistor is illustrated. When $R > \frac{2\sqrt{LC}}{C}$ is satisfied, the lateral field-effect transistor may be performed in an overdamped state, which may further mitigate gate oscillation, reduce loss, and avoid false turn-on through the RLC series resonant circuit. In some embodiments, as shown in FIG. 1, the drain pad 103 is also arranged in the passive region 102 of the functional layer. The drain pad 103 may be connected to a drain electrode 118 of an active device in the active region 101.

In some embodiments, the source pad 106 may be configured to be grounded. The drain electrode 118 may be configured to be connected to a power supply.

In some embodiments, since the dielectric layer 113 acts as a dielectric for the capacitance formed by the gate pad 104 and the source pad 106 shorted to the substrate 108, the magnitude of the device gate-source capacitance C may be adjusted correspondingly by changing the thickness and material of the dielectric layer 113. For example, when it is desired to adjust the device gate-source capacitance C at a certain value, the gate-source capacitance C may configure to be at a certain value by changing one or a combination of either the thickness and the material.

In some embodiments, the breakdown voltage of the capacitance formed by the gate pad 104 and the source pad 106 shorted to the substrate 108 may be higher than the actual operating voltage of the lateral field-effect transistor, so that the stability of the device may be effectively improved.

In some embodiments, the thickness and material of the dielectric layer 113 may be reasonably selected in view of the requirements of the breakdown voltage of the capacitance formed by the gate pad 104 and the source pad 106 and the requirements of the device gate-source capacitance C.

In some embodiments, the depth of the first slot 105 and/or the second slot 107 is greater than the thickness of the device functional layer. For example, a typical epitaxial thickness of 650V GaN HEMT is 5 $\mu$m, and the depth of the first slot 105 and/or the second slot 107 slot needs to be greater than 5 um, etched into the surface of the substrate 108.

In some embodiments, the thickness of the dielectric layer 113 may be greater than 5 nm, such as 5 nm, 10 nm, 15 nm, etc., so that the breakdown voltage requirement and the gate-source capacitance C may be matched. For example, when the GaN E-HEMT gate operating voltage is 6V, the dielectric material is SiO2, the typical breakdown electric field is 6MV/cm, the thickness of the dielectric layer 113 needs to be greater than 10nm.

In some embodiments, the material of the dielectric layer 113 may be selected from a group of $SiO_2$, $Si_3N_4$ and $Al_2O_3$. In some embodiments, the dielectric layer 113 may be a stack layer of $Si_3N_4/Al_2O_3$, which means the dielectric layer 113 is a dielectric stack, i.e., a $Si_3N_4$ layer is deposited first and then the $Al_2O_3$ layer continues to be deposited on top of the $Si_3N_4$ layer.

In some embodiments, the lateral field-effect transistor is a HEMT device, and the HEMT device includes a substrate 108 and a device functional layer arranged on the substrate 108. Both the substrate 108 and the device functional layer include a portion arranged in the active region 101 and a portion arranged in the passive region 102.

In some embodiments, the device functional layer may include a plurality of active semiconductor layers formed on the substrate 108. The plurality of active semiconductor layers is disposed in the active region 101 and the passive region 102. 2DEG is defined at hetero-interface(s) between two of the plurality of active semiconductor layers in the active region 101; and the two-dimensional electron gas is not defined at hetero-interface(s) between two of the plurality of active semiconductor layers in the passive region 102 (the process of excluding the two-dimensional electron gas may be ion implantation, etc.).

In some embodiments, when the lateral field-effect transistor is a HEMT device, the HEMT device includes a substrate 108 and a device functional layer formed on the substrate 108, wherein, as shown in FIG. 7, the plurality of active semiconductor layers included in the device functional layer may be: a nucleation layer (not shown in the figure) formed on the substrate 108, which reduces the lattice mismatch between the substrate 108 and the next active semiconductor layer; a buffer layer 109 and a channel layer 110 formed on the nucleation layer in sequence; a barrier layer 111 formed on the channel layer 110, with the 2DEG formed between the channel layer 110 and the barrier layer 111 (the portion located in the passive region 102 is removed); the passivation layer 116 formed on the barrier layer 111; a source electrode 117 and drain electrode 118 form on the passivation layer 116 in contact with the barrier layer 111; a gate electrode in contact with the barrier layer 111 is formed between the source electrode 117 and the drain electrode 118.

In some embodiments, the gate electrode may include a p-doped layer 119 formed on the barrier layer 111 and a gate metal 120 formed on top of the p-doped layer 119, as shown in FIG. 7.

In some embodiments, the substrate 108 is made of silicon carbide, sapphire, spinel, zinc oxide, silicon, gallium nitride, aluminum nitride, or any other material capable of supporting the growth of group III nitride materials.

In some embodiments, the nucleation layer may include a variety of different materials, such as $Al_xGa_{1-x}N$ ($0 \leq x \leq 1$) The nucleation layer may be formed on the substrate 108 using present semiconductor growth technologies such as metal oxide chemical vapor deposition (MOCVD), hydride vapor phase epitaxy (HVPE), or molecular beam epitaxy (MBE).

In some embodiments, the buffer layer 109 and the channel layer 110 may be formed by a group III nitride material such as $Al_xGa_yIn_{1-x-y}N$ ($0 \leq x \leq 1, 0 \leq y \leq 1 x + y \leq 1$). For example, the buffer layer 109 and the channel layer 110 are GaN layers. In some other embodiments, the GaN layers can be doped with Fe. The buffer layer 109 and the channel layer 110 may be formed using the same methods as growing nucleation layers.

In some embodiments, each of the barrier layer 111 and the channel layer 110 may include doped or undoped group III nitride material. The barrier layer 111 may contain one or more layers of different materials such as InGaN, AlGaN, AlN, or combinations thereof. The barrier layer 111 can be fabricated using the same methods used to grow the nucleation layer.

In some embodiments, the source pad 106 is made of one of titanium, aluminum, gold, and nickel, or an alloy of several of titanium, aluminum, gold, and nickel; in some embodiments, the gate pad 104 is made of one of nickel, gold, platinum, titanium, chromium, titanium, and tungsten, or an alloy of several of nickel, gold, platinum, titanium, chromium, titanium, and tungsten, or platinum silicide; in some embodiments, the drain pad 103 is of one of titanium, aluminum, gold, and nickel, or an alloy of several of titanium, aluminum, gold, and nickel.

In some embodiments, the material of the source electrode 117 is one of titanium, aluminum, gold, and nickel, or an alloy of several of titanium, aluminum, gold, and nickel; in some embodiments; in some embodiments, the material of the gate electrode is one of nickel, gold, platinum, titanium, chromium, titanium, and tungsten, or an alloy of several of nickel, gold, platinum, titanium, chromium, titanium, and tungsten, or platinum silicide; in some embodiments, the material of the drain electrode 118 is one of titanium or an alloy of titanium, aluminum, gold, and nickel, or an alloy of several of titanium, aluminum, gold, and nickel.

The above described is only a preferred embodiment of the present disclosure only and is not intended to limit the present disclosure, for those skilled in the art, the present disclosure can have various changes and variations. Any modifications, equivalent replacements, improvements, etc. made within the spirit and principles of the present disclosure shall be included within the scope of protection of the present disclosure.

**Claims**

1. A lateral field-effect transistor, comprising:

   a substrate;
   a device functional layer, arranged on the substrate, and comprising a first surface far away from the substrate;
   wherein the lateral field-effect transistor is configured with an active region and a passive region; a gate pad is arranged in the passive region, and the gate pad extends from the first surface to a surface of the substrate; the gate pad is insulated from the substrate and the device functional layer; a source pad is arranged in the passive region, and the source pad extends from the first surface to the surface of the substrate.

2. The transistor as claimed in claim 1, further comprising:

   a first slot, extending from the first surface to the surface of the substrate, wherein the gate pad comprises a first gate-pad portion and a second gate-pad portion; the first gate-pad portion is arranged on the first surface around the circumference of the first slot; and the second gate-pad portion fills the first slot;
a dielectric layer, comprising a first dielectric-layer portion and a second dielectric-layer portion, wherein the first dielectric-layer portion is arranged on the side wall and the bottom wall of the first slot; the second dielectric-layer portion is arranged on the first surface;
a second slot, extending from the first surface to the surface of the substrate, wherein the source pad comprises a first source-pad portion and a second source-pad portion; the first source-pad portion is arranged on the first surface around the circumference of the second slot; the second source-pad portion fills the second portion of the second slot.

3. The transistor as claimed in claim 2, wherein the passive region comprises a first side portion at a side of the active region; and the first slot and the second slot are both arranged on the first side portion.

4. The transistor as claimed in any of claims 1-3, further comprising:
a gate electrode, a source electrode, and a drain electrode, arranged in the active region, wherein the gate pad is electrically connected to the gate electrode, the source pad is electrically connected to the source electrode; in response to the transistor being configured that the gate pad is connected in series with a gate driving circuit, a resistance of a circuit structure formed by the connection of the gate electrode, the gate pad and the gate driving circuit, is R; a parasitic inductance of the circuit structure formed by the connection of the gate electrode, the gate pad and the gate driving circuit, is L; a gate-source capacitance C of the transistor satisfies $R > \frac{2\sqrt{LC}}{C}$ .

5. The transistor as claimed in claim 4, wherein the source pad is configured to be grounded; the drain electrode is configured to be connected to a power supply.

6. The transistor as claimed in any of claims 1-3, wherein the transistor is a HEMT device; the device functional layer comprises a plurality of active semiconductor layers formed on the substrate; two-dimensional electron gas (2DEG) is defined at hetero-interface(s) between at least two of the active semiconductor layers.

7. The transistor as claimed in claim 6, wherein the active semiconductor layers are made of III-V compound.

8. The transistor as claimed in claim 2, wherein the thickness of the dielectric layer is greater than 5 nm; and/or, the dielectric layer is a layer made of a material selected from a group of $SiO_2$, $Si_3N_4$ and $Al_2O_3$; or the dielectric layer is a stacked layer of $Si_3N_4$ layer(s) and $Al_2O_3$ layer(s).

9. The transistor as claimed in claim 2, wherein the depth of the first slot is greater than the thickness of the device functional layer; and/or, the depth of the second slot is greater than the thickness of the device functional layer.

10. The transistor as claimed in claim 1, wherein the source pad is made of a material selected from a group of titanium, aluminum, gold, and nickel, or an alloy of multi materials selected from a group of titanium, aluminum, gold, and nickel; and/or the gate pad is made of a material selected from a group of nickel, gold, platinum, titanium, chromium, titanium, and tungsten, or an alloy of multi materials selected from a group of nickel, gold, platinum, titanium, chromium, titanium, and tungsten, or a material of platinum silicide.

11. A method for preparing a lateral field-effect transistor, comprising:

   providing a device structure, comprising a substrate and a device functional layer, wherein the device functional layer is arranged on the substrate; the device functional layer comprises a first surface far away from the substrate; the device structure is configured with a first region for forming an active region and a second region for forming a passive region;
   forming a first slot and a second slot extending from the first surface to the substrate in the second region;
   forming a dielectric layer, comprising a first dielectric-layer portion and a second dielectric-layer portion, wherein the first dielectric-layer portion is arranged on the circumference and bottom wall of the first slot; the second dielectric-layer portion is arranged on the first surface;
   forming a gate pad, comprising a first gate-pad portion and a second gate-pad portion, wherein the first gate-pad portion is arranged on the first surface around the circumference of the first slot; the second gate-pad portion fills the first slot;
   forming a source pad, comprising a first source-pad portion and a second source-pad portion, wherein the first source-pad portion of the source pad is arranged on the first surface around the circumference of the second slot; the second source-pad portion of the source pad fills the second slot.

12. The method as claimed in claim 11, wherein the transistor is a HEMT device; the device functional layer comprises a plurality of active semiconductor layers formed on the substrate; a two-dimensional electron gas (2DEG) is defined at hetero-interface(s) between at least two of the active semiconductor layers; the active semiconductor layers are made of III-V compound.

13. The method as claimed in claim 11, wherein the thickness of the dielectric layer is greater than 5 nm; and/or, the dielectric layer is a layer made of a material selected from a group of $SiO_2$, $Si_3N_4$ and $Al_2O_3$ or the dielectric layer is a stacked layer of $Si_3N_4$ layer(s) and $Al_2O_3$ layer(s).

14. The method as claimed in claim 11, wherein the depth of the first slot is greater than the thickness of the device functional layer; and/or, the depth of the second slot is greater than the thickness of the device functional layer.

103

102

101

A — · — · — · — · — · — · — · — · — · — · — · — A'

104

105        106        107

**FIG. 1**

111

110

109

108

**FIG. 2**

112

111

110

109

108

**FIG. 3**

105    107    107    111
110
109
108

FIG. 4

113    105    107    107    111
110
109
108

FIG. 5

104    113    106    111
110
109
108

FIG. 6

FIG. 7

FIG. 8

providing a device structure, comprising a substrate and a device functional layer, wherein the device functional layer is arranged on the substrate; the device functional layer comprises a first surface away from the substrate; the device structure is configured with a first region for forming an active region and a second region for forming a passive region ⟶ S010

forming a first slot and a second slot extending from the first surface to the substrate in the second region ⟶ S020

forming a dielectric layer, comprising a first dielectric layer portion and a second dielectric layer portion, wherein the dielectric layer portion of the dielectric layer is arranged on the circumference and bottom wall of the first slot; the second dielectric layer portion of the dielectric layer is arranged on the first surface ⟶ S030

forming a gate pad, comprising a first gate pad portion and a second gate pad portion, wherein the first gate pad portion of the gate pad is arranged on the first surface around the circumference of the first slot; the second gate pad portion of the gate pad fills the first slot ⟶ S040

forming a source pad, comprising a first source pad portion and a second source pad portion, wherein the first source pad portion of the source pad is arranged on the first surface around the circumference of the second slot; the second source pad portion of the source pad fills the second slot ⟶ S050

FIG. 9

<div align="center">

**INTERNATIONAL SEARCH REPORT**

</div>

| International application No. |
|---|
| **PCT/CN2022/118904** |

| **A.** | **CLASSIFICATION OF SUBJECT MATTER** |
|---|---|

H01L 29/417(2006.01)i; H01L 29/423(2006.01)i; H01L 29/778(2006.01)i; H01L 29/78(2006.01)i; H01L 21/335(2006.01)i; H01L 21/336(2006.01)i

According to International Patent Classification (IPC) or to both national classification and IPC

| **B.** | **FIELDS SEARCHED** |
|---|---|

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNTXT; ENTXT; ENTXTC; DWPI; CNKI: 横向, 场效应管, 衬底, 功能层, 有源区, 无源区, 栅, 源, 焊盘, 槽, 短接, 电容, lateral, field effect transistor, substrate, functional layer, active area, passive area, gate, source, pad, trench, short circuit, capacitance

| **C.** | **DOCUMENTS CONSIDERED TO BE RELEVANT** | |
|---|---|---|

| Category* | Citation of document, with indication, where appropriate, of the relevant passages | Relevant to claim No. |
|---|---|---|
| PX | CN 114335165 A (XIAMEN SANAN INTEGRATED CIRCUIT CO., LTD.) 12 April 2022 (2022-04-12)<br>description, paragraphs [0027]-[0082], figures 1-9, and claims 1-14 | 1-14 |
| X | CN 104465778 A (UNIVERSITY OF ELECTRONIC SCIENCE AND TECHNOLOGY OF CHINA) 25 March 2015 (2015-03-25)<br>description, paragraphs [0038]-[0059], and figures 2-15 | 1-14 |
| A | CN 105336789 A (SUN YAT-SEN UNIVERSITY) 17 February 2016 (2016-02-17)<br>entire document | 1-14 |
| A | CN 113113495 A (SOUTHEAST UNIVERSITY) 13 July 2021 (2021-07-13)<br>entire document | 1-14 |
| A | CN 212725321 U (HEJIAN TECHNOLOGY (SUZHOU) CO., LTD.) 16 March 2021 (2021-03-16)<br>entire document | 1-14 |
| A | US 2004046199 A1 (INTELLIGENT SOURCES DEVELOPMENT CORP.) 11 March 2004 (2004-03-11)<br>entire document | 1-14 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **15 November 2022** | **23 November 2022** |

| Name and mailing address of the ISA/CN | Authorized officer |
|---|---|
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT
### Information on patent family members

International application No.

**PCT/CN2022/118904**

| Patent document cited in search report | | | Publication date (day/month/year) | Patent family member(s) | | | Publication date (day/month/year) |
|---|---|---|---|---|---|---|---|
| CN | 114335165 | A | 12 April 2022 | None | | | |
| CN | 104465778 | A | 25 March 2015 | None | | | |
| CN | 105336789 | A | 17 February 2016 | None | | | |
| CN | 113113495 | A | 13 July 2021 | CN | 113113495 | B | 05 July 2022 |
| CN | 212725321 | U | 16 March 2021 | None | | | |
| US | 2004046199 | A1 | 11 March 2004 | US | 6744089 | B2 | 01 June 2004 |

Form PCT/ISA/210 (patent family annex) (January 2015)